# EUROPÄISCHE PATENTANMELDUNG

(11) **EP 4 803 911 A1**
(43) Veröffentlichungstag der Anmeldung: **09.09.2026**
(21) Anmeldenummer: 25162230.4
(22) Anmeldetag: 07.03.2025
(51) Int. Cl.: G01R 31/08, G01R 31/11

(54) **FEHLERORTUNG BASIEREND AUF FREQUENZABHÄNGIGER ZEITDIFFERENZ**

(71) Anmelder: Siemens Aktiengesellschaft, 80333 München (DE)
(72) Erfinder: Jurisch, Andreas, 16727 Schwante (DE)
(74) Vertreter: Siemens Patent Attorneys

(57) **Zusammenfassung**

Es wird eine Vorrichtung (100), insbesondere zur Fehlerortung, beschrieben, aufweisend:
i) eine Erfassungsvorrichtung (110) zum Erfassen eines ersten Signals (x1) und eines zweiten Signals (x2),
wobei das erste Signal (x1) und das zweite Signal (x2) zueinander zeitverschoben sind; und
ii) eine Steuervorrichtung (120), eingerichtet zum
a) Bestimmen eines ersten Frequenzspektrums (121) bezüglich des ersten Signals (x1) und eines zweiten Frequenzspektrums (122) bezüglich des zweiten Signals (x2),

iii) Bestimmen einer Phasendifferenz (125) bezüglich dem ersten Frequenzspektrum (121) und dem zweiten Frequenzspektrum (122), und
iv) Bestimmen einer frequenzabhängigen Zeitdifferenz (128) zwischen dem ersten Signal (x1) und dem zweiten Signal (x2) basierend auf der bestimmten Phasendifferenz (125).

## Beschreibung

### Technisches Gebiet

Die Erfindung bezieht sich auf eine Vorrichtung, aufweisend: eine Erfassungsvorrichtung zum Erfassen eines ersten Signals und eines zweiten Signals, wobei das erste Signal und das zweite Signal zueinander zeitverschoben sind, und eine Steuervorrichtung, eingerichtet zum Bestimmen eines ersten Frequenzspektrums bezüglich des ersten Signals und eines zweiten Frequenzspektrums bezüglich des zweiten Signals, Bestimmen einer Phasendifferenz bezüglich dem ersten Frequenzspektrum und dem zweiten Frequenzspektrum, und Bestimmen einer frequenzabhängigen Zeitdifferenz zwischen dem ersten Signal und dem zweiten Signal basierend auf der bestimmten Phasendifferenz. Die Erfindung betrifft weiterhin ein korrespondierendes Verfahren zur Fehlerortung.

Die Erfindung kann sich somit auf das technische Gebiet der Fehlerortung, insbesondere in Energieübertragungsnetzen und/oder Verteilnetzen beziehen, weiter insbesondere in Hinblick auf Wanderwellen ausgelöst durch Erdschlüsse bei einer Energieanwendung.

### Technischer Hintergrund

Netze wie Hochspannungsnetze oder Mittelspannungsnetze spielen eine wichtige Rolle in der Energieversorgung. Entsprechend ist es daher von Bedeutung, einen zuverlässigen und fehlerfreien Betrieb dieser Netze sicherzustellen. Fehler-Ereignisse wie Fehlströme (insbesondere Erdschlüsse bzw. Kurzschlüsse) müssen daher erfasst und auch geortet werden, um möglichst effizient Abhilfe schaffen zu können. Fehlströme wie Erdschlüsse können beispielsweise Wanderwellen im Netz auslösen, die dann detektiert werden und eine Lokalisierung der Fehlerstelle ermöglichen können.

Wanderwellen-Verfahren werden in Energieübertragungs- und Verteilnetzen eingesetzt, um Erdschlüsse präzise zu orten, indem die Zeitdifferenz zwischen ankommenden Wellenfronten an verschiedenen Messpunkten (Fehler-Detektoren) analysiert wird. Wanderwellen-Fehlerortung ist zwar zuverlässig und genau, erfordert aber auch einen hohen technischen Aufwand für Erfassung der Wanderwellen-Ereignisse, deren Umspannwerk-übergreifende Kommunikation sowie der Rückübertagung der Ortungsergebnisse in die Automatisierung.

Aufgrund dieses hohen technischen Aufwandes wird diese Technik der genauen Fehlerortung bisher nur in einigen Hochspannungsnetzen eingesetzt. Eine flächendeckende Anwendung, insbesondere auch in Mittelspannungsnetzen, erscheint derzeit aufgrund des hohen Kostenaufwandes wirtschaftlich nicht sinnvoll.

Bei der ein- oder zwei-seitiger (Wanderwellen) Fehlerortung werden Zeitdifferenzen zwischen am Messort (einseitige Fehlerortung) oder an zwei verschiedenen Messorten (zweiseitige Fehlerortung) eintreffenden Wellenfronten (der Wanderwelle) gemessen. Um eine hohe zeitliche Auflösung dieser Zeitdifferenzen zu ermöglichen, sind konventionell sehr hohe Abtastraten der zur Erfassung der Wellenfronten verwendeten Abtastsysteme erforderlich. Die dazu notwendigen Komponenten (z.B. Analog-Digital-Wandler, ADCs) sind teuer und haben einen hohen Energieverbrauch. Gleichzeitig haben Abtastsysteme mit hoher Bandbreite einen geringeren Signal-Rausch-Abstand, da die entstehende Widerstands-Rauschspannung proportional zur Wurzel der Bandbreite ist.

Die bisher bekannten Verfahren zur Erfassung von Zeitdifferenzen arbeiten stets im Zeitbereich, beispielsweise:
Zeitstempel des Wanderwellen-Peak: Nachteil dieses Verfahrens ist die große Ungenauigkeit der Flankenerkennung durch das Verwenden einer festen Trigger-Schwelle und die erforderliche hohe Abtastrate zur Erkennung des Zeitpunktes. Abweichungen in der Amplitude der eintreffenden Wellenfront und unterschiedliche Anstiegsgradienten führen zu erheblichen Messfehlern.

Zeitstempel des Wanderwellen-Beginns: Dieses Verfahren erreicht eine etwas höhere Genauigkeit durch Bestimmung des Anstiegsgradienten der steigenden Flanke der Wellenfront. Der Nulldurchgang der Gerade des Wellenfront-Gradienten wird hier als Beginn der Wellenfront definiert. Nachteil ist neben den verbleibenden Ungenauigkeiten bei der Bestimmung des Beginns der Wellenfront, durch nicht konstante Gradienten der steigenden Flanke der Wellenfront, ebenfalls die erforderliche hohe Abtastrate, um mindestens zwei Abtastwerte innerhalb der steigenden Flanke der Wellenfront zu haben. Andernfalls wäre eine Gradienten-Bestimmung nicht möglich.

Bestimmen der Ankunftszeit unter Verwenden eines Differentiator-Glätters: Dieses Verfahren benutzt eine Tiefpassfilterung mit anschließender Differenzierung der Abtastwerte, um Ungenauigkeiten durch unterschiedliche Filterung der Wellenfront durch unterschiedlich lange Laufwege auf der Leitung zu verringern. Durch die Verwendung des Spitzenwertes des differenzierten Signals wird das Verfahre relativ unempfindlich gegen unterschiedliche Amplituden der zu vergleichenden Wellenfronten. Zur Bestimmung des Peak-Zeitpunktes mithilfe von zwei Geraden, welche die ansteigende und abfallende Flanke des differenzierten Signales interpolieren, sind mindestens zwei Abtastwerte auf beiden Flanken des differenzierten Signals erforderlich. Dafür ist wiederum eine sehr hohe Abtastrate erforderlich.

SEL (selective earth fault) benutzt eine verfeinerte Methode zur Bestimmung des Eintreffzeitpunktes der Wellenfront. Statt den Peak des differenzierten Signales mit zwei Geraden zu interpolieren, werden die Abtastwerte um den Peak des differenzierten Signals durch eine Parabel interpoliert (das kann mithilfe eines Koeffizientenvergleichs bei Verwendung von vier Abtastwerten oder mittels eines LS-Schätzers unter Verwendung von zusätzlichen redundanten Abtastwerten erfolgen). Zur Durchführung dieses Verfahrens werden ebenfalls wieder mindestens vier Abtastwerte auf der differenzierten ansteigenden Flanke der Wellenfront benötigt. Dafür ist wiederum eine sehr hohe Abtastrate erforderlich.

Allen bekannten Verfahren gemeinsam ist eine erforderliche Mindest-Abtastrate von 1-2 MHz, besser > 5 MHz.

Damit können die bisher beschriebenen Verfahren zur Detektion einer Wellenfront nur im zweiseitigen Fehlerorter eingesetzt werden, weil man hier für Frequenzen > 2 kHz von einer konstanten Ausbreitungsgeschwindigkeit in den aerial modes (Alpha- und Beta-Mode der Clarke-Transformation) ausgehen kann und im zweiseitigen Fehlerorter ausschließlich diese aerial modes (asymmetrischer Teil der Phasen) verwendet werden. Beim einseitigen Fehlerorter wäre die Verwendung des Zero-Modes (symmetrischer Teil der Phasen) mit frequenzabhängigen Ausbreitungsgeschwindigkeiten aber zwingend erforderlich.

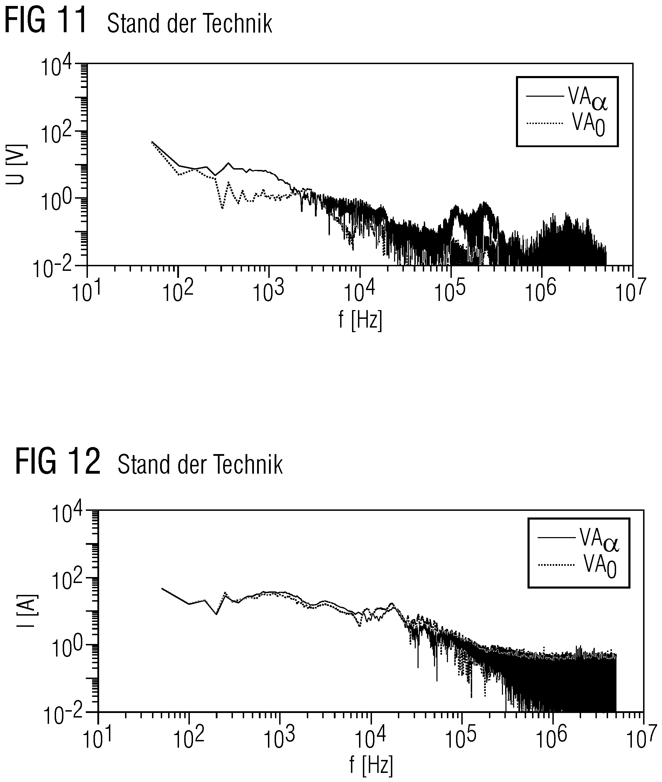

Die **Figur 11** (Spannung/Frequenz Diagramm) und die **Figur 12** (Strom/Frequenz Diagramm) zeigen Spektren der Signale von einem Wanderwellen-Recorder mit einer Abtastrate von 10 MHz. Es ist zu erkennen, dass die Signale ab einer Frequenz von > 200 kHz im Rauschteppich verschwinden; damit ist die nutzbare Bandbreite auf den Frequenzbereich bis 200 kHz eingeschränkt. Die hohe Abtastrate führt also nicht dazu, dass die durch die Abtastrate mögliche Bandbreite bis zur Nyquist-Frequenz von 5 MHz (Abtastrate 10 MHz/2) auch genutzt werden kann.

Konventionelle Verfahren, die stets im Zeitbereich arbeiten, können somit trotz hoher Abtastrate keine hohe Auflösung erreichen.

### Zusammenfassung der Erfindung

Es kann ein Bedarf bestehen, einen Fehler in einem Netz effizient und zuverlässig zu orten, insbesondere die Abtastrate zu verringern.

Eine Vorrichtung und ein Verfahren werden im Folgenden beschrieben.

Gemäß einem ersten Aspekt der Erfindung wird eine Vorrichtung (insbesondere ein Fehlerorter bzw. eine Vorrichtung zum Orten eines Fehlers) beschrieben, aufweisend:
i) eine Erfassungsvorrichtung (z.B. ein oder mehr Wellendetektor(en)) zum Erfassen (Messen) eines ersten Signals (z.B. eine erste Wellenfront einer Wanderwelle, insbesondere ein erster Puls) (insbesondere an einer ersten Erfassungsvorrichtung) und eines zweiten Signals (z.B. die erste Wellenfront der Wanderwelle, insbesondere ein zweiter Puls) (insbesondere an einer zweiten Erfassungsvorrichtung). Insbesondere sind das erste Signal und das zweite Signal zueinander zeitverschoben (obwohl sie von demselben Fehlerort ausgehen).
ii) eine Steuervorrichtung (z.B. ein Prozessor, eine Hardware/Software, eine Systemsteuerung, etc.), eingerichtet zum Bestimmen
   a) eines ersten Frequenzspektrums bezüglich des ersten Signals und eines zweiten Frequenzspektrums bezüglich des zweiten Signals (insbesondere mittels Fouriertransformation),
   b) einer Phasendifferenz (Differenz der Phasenwinkel) bezüglich des (zwischen dem) ersten Frequenzspektrum und dem zweiten Frequenzspektrum (insbesondere unter Berücksichtigung von Leitungseigenschaften), und
   c) einer frequenzabhängigen Zeitdifferenz zwischen dem ersten Signal und dem zweiten Signal basierend auf der bestimmten Phasendifferenz.

Gemäß einem zweiten Aspekt der Erfindung wird ein Verfahren (insbesondere zur Fehlerortung bzw. Bestimmen eines Fehlerorts) beschrieben, das Verfahren aufweisend:
i) Erfassen/Erhalten eines ersten Signals und eines zweiten Signals, insbesondere wobei das erste Signal und das zweite Signal zueinander zeitverschoben sind;
ii) Bestimmen eines ersten Frequenzspektrums bezüglich des ersten Signals und eines zweiten Frequenzspektrums bezüglich des zweiten Signals;
iii) Bestimmen einer Phasendifferenz zwischen dem ersten Frequenzspektrum und dem zweiten Frequenzspektrum; und
iv) Bestimmen einer frequenzabhängigen Zeitdifferenz zwischen dem ersten Signal und dem zweiten Signal basierend auf der bestimmten Phasendifferenz.

Gemäß einem dritten Aspekt der Erfindung wird eine Energievorrichtung beschrieben, insbesondere aufweisend zumindest ein Schutzgerät, wobei die Energievorrichtung die oben beschriebene Vorrichtung aufweist.

Gemäß einem vierten Aspekt der Erfindung wird ein (vermaschtes) Netz beschrieben, z.B. ein Mittelspannungsnetz, das eine Mehrzahl von Vorrichtungen oder Energievorrichtungen wie oben beschrieben aufweist.

Im vorliegenden Kontext kann der Begriff "Signal" insbesondere eine physikalische Größe bezeichnen, die sich in Raum/Zeit in Form einer Welle ausbreitet. In einem Ausführungsbeispiel ist das Signal mit einer Wanderwelle assoziiert, die z.B. durch einen Fehlstrom ausgelöst wird. In einem Ausführungsbeispiel kann ein erstes Signal mit einer ersten Wellenfront (der Wanderwelle) assoziiert sein. In einem weiteren Ausführungsbeispiel kann ein zweites Signal mit der ersten Wellenfront oder einer zweiten Wellenfront (der Wanderwelle) assoziiert sein. Ein Fehlstrom löst gewöhnlich lediglich einen Puls aus, so dass das Signal als Wellenfront-Puls vorliegen kann. In einem ersten Ausführungsbeispiel (insbesondere zweiseitiger Fehlerorter) wird das erste Signal an einem ersten Messort (z.B. erste Erfassungseinheit) erfasst und das zweite Signal wird an einem räumlich entfernten zweiten Messort (z.B. zweite Erfassungseinheit) erfasst. Beide Signale haben denselben Ursprung (z.B. der Fehlstrom), aber erreichen die unterschiedlichen Messorte zu verschiedenen Zeiten (Zeitdifferenz). In einem zweiten Ausführungsbeispiel (insbesondere einseitiger Fehlerorter) werden beide Signale an demselben Messort erfasst. Eine Zeitdifferenz zwischen dem ersten Signal und dem zweiten Signal kann in diesem Fall durch die Leitung selbst bedingt sein, beispielsweise kann durch Reflexion eine Verzögerung hervorgerufen werden. In einem Ausführungsbeispiel wird die von der Fehlerstelle ausgehende Welle teilweise an der Messstelle in die Leitung zurück reflektiert und an der Fehlerstelle wieder reflektiert. Der zeitliche Abstand der ersten einlaufenden Welle zu dieser dritten Reflektion kann dann gemessen werden.

Im vorliegenden Kontext kann der Begriff "Erfassungsvorrichtung" insbesondere eine Vorrichtung bezeichnen, die geeignet ist zum Erfassen/Erhalten/Messen von dem ersten Signal und dem zweiten Signal. Die Erfassungsvorrichtung kann sich an einem einzigen Messort befinden oder auf zwei oder mehr Messorte aufgeteilt werden. In einem Ausführungsbeispiel weist die Erfassungsvorrichtung eine erste Erfassungseinheit (zum Erfassen des ersten Signals) an einem ersten Messort und eine zweite Erfassungseinheit (zum Erfassen des zweiten Signals) an einem zweiten Messort auf. Zusätzlich oder alternativ können auch an einem einzigen Messort zwei oder mehr Erfassungseinheiten vorgesehen werden. In einem exemplarischen Ausführungsbeispiel kann eine Erfassungsvorrichtung einen (Wander-) Wellendetektor aufweisen. Ferner kann eine Erfassungsvorrichtung einen Sensor, eine Antenne, oder einen Recorder aufweisen. In einem weiteren Ausführungsbeispiel kann eine Erfassungsvorrichtung die Signale auch passiv (ohne eigene aktive Messung) von einem anderen Gerät bereitgestellt bekommen.

Im vorliegenden Kontext kann der Begriff "Steuervorrichtung" insbesondere eine Vorrichtung bezeichnen, die geeignet ist zum Bestimmen eines Frequenzspektrums aus einem Signal (z.B. mittels Fourier-Transformation), einer Phasendifferenz zwischen den zwei Frequenzspektren, und einer frequenzabhängigen Zeitdifferenz aus der Phasendifferenz. Eine solche Steuervorrichtung kann hierfür ein oder mehr Prozessoren aufweisen. Die Steuervorrichtung kann eine Hardware/Software aufweisen oder als Systemsteuerung (eines Fehlerorters) ausgestaltet sein. In einem weiteren Beispiel kann die Steuervorrichtung räumlich an zwei oder mehr Orte verteilt sein (als Steuervorrichtung-Einheiten). Die Steuervorrichtung kann in einem Beispiel (teilweise) im Fernbetrieb (zu der Erfassungsvorrichtung) operieren.

Im vorliegenden Kontext kann der Begriff "Fehlstrom" insbesondere ein unerwünschtes Strom-Ereignis beschreiben, z.B. einen Erdschluss und/oder einen Kurzschluss. Ein solcher Fehlstrom kann eine Wanderwelle auslösen, die entlang einer Leitung (durch ein Netz) läuft. Anhand der Wanderwelle kann der Fehlstrom erfasst und auch geortet werden.

Gemäß einem exemplarischen Ausführungsbeispiel kann die Erfindung auf der Idee basieren, dass ein Fehler, insbesondere ein Fehlstrom, in einem Netz effizient und zuverlässig geortet werden kann, wenn die frequenzabhängige Zeitdifferenz zwischen zwei Signalen (Wellenfront-Pulsen) bestimmt wird (über die Phasendifferenz der Frequenzspektren).

Konventionell (siehe oben) wird die Frequenzabhängigkeit der Ausbreitungsgeschwindigkeit einer Wellenfront über eine Leitung nicht berücksichtigt. Stattdessen wird lediglich die Zeitdifferenz im Zeitbereich berücksichtigt, wobei sehr hohe Abtastraten notwendig sind, die aber dennoch nur eine geringe Auflösung ermöglichen.

Durch die Messung der (Puls-) Zeitdifferenz im Frequenzbereich wird erfindungsgemäß eine Messung der Zeitdifferenz als Funktion der Frequenz möglich, während die bekannten Verfahren nur eine skalare Zeitdifferenz messen können. Damit eignet sich das Verfahren nicht nur zum Einsatz in einem zweiseitigen (Wanderwellen-) Fehlerorter, sondern es kann auch in einem einseitigen (Wanderwellen-) Fehlerorter eingesetzt werden. Dort kann die Messung der frequenzabhängigen Zeitdifferenz zwingend erforderlich sein. Besonders im Nullsystem (im Kontext von Clarke Komponenten) kann die frequenzabhängige Ausbreitungsgeschwindigkeit einer Wellenfront notwendig sein.

Erfindungsgemäß können nun frequenzabhängige Zeitdifferenzen gemessen werden, wobei eine hohe zeitliche Auflösung auch mit geringerer Abtastrate erreicht werden kann. Weiterhin kann durch Verringerung der Abtastrate eine höhere nutzbare Bandbreite erzielt werden, weil durch den besseren Signal-Rausch-Abstand des Abtastsystems mit geringerer Abtastrate ein größerer Teil der verfügbaren Bandbreite oberhalb des Rauschteppichs liegt.

Das Abtastintervall kann sogar auf einen größeren Wert als die erforderliche Genauigkeit der Zeitauflösung vergrößert werden. Dadurch wird der Einsatz von günstigen und energiesparenden Abtastvorrichtungen (insbesondere Delta-Sigma ADCs) möglich. Die dadurch beträchtlich sinkenden Systemkosten für einen (Wanderwellen-) Fehlerorter erlaubt den Einsatz dieser Geräte nicht nur wie bisher in der Hochspannung, sondern ermöglicht den Einsatz der (Wanderwellen-) Fehlerortung im preissensitiven Mittelspannungssegment.

Gemäß einem exemplarischen Ausführungsbeispiel wird das bekannte (siehe oben) Abtastratenproblem dadurch gelöst, dass die Bestimmung der Zeitdifferenzen zwischen zwei Wellenfront-Pulsen im Frequenzbereich unter Ausnutzung des Verschiebungssatzes der Fouriertransformation bestimmt werden.

Die folgende Formel zeigt den Verschiebungssatz der Fouriertransformation: $F \left\{f\left(t-{t}_{0}\right)\right\} = F \left\{f\left(t\right)\right\} ⋅ {e}^{- j 2 πf ⋅ {t}_{0}}$

Das Zeitsignal der ersten Flanke f(t) breitet sich von der Fehlerstelle über die Leitung zu den Messorten aus und wird von einem Gerät am Terminal A als f_{A}(t) und vom Gerät am Terminal B als f_{B}(t) gemessen. Es handelt sich in beiden Fällen um das gleiche Signal, nur zeitverschoben und entsprechend dem Laufweg über die Leitung gedämpft. Damit ergeben sich für die gemessenen Signale folgende Formel: $F \left\{{f}_{A}\left(t\right)\right\} = F \left\{f\left(t\right)\right\} ⋅ {e}^{- jγl}$

Die frequenzabhängige Funktion der Ausbreitungskonstante entlang einer homogenen Leitung γ kann in Real- und Imaginärteil zerlegt werden: $γ \left(jω\right) = α \left(jω\right) + jβ \left(jω\right)$

Somit ergibt sich folgende Formel zur Ermittlung der an der Messtelle A eintreffenden Signale: $F \left\{{f}_{A}\left(t\right)\right\} = F \left\{f\left(t\right)\right\} ⋅ {{{e}^{αl}}_{︸}}_{D ä mpfung} ⋅ {{{e}^{- jβl}}_{︸}}_{Verz ö gerung}$

Die von Fehlerort aus über die Leitung wandernde Wellenfront f(t) kommt am Messort A gedämpft um den Faktor e^{αl}(ω) und zeitverzögert um die Zeit $\frac{βl}{ω} \left(ω\right)$ (siehe Verschiebungssatz) an.

Gleiches gilt für die Seite B. Teilt man jetzt die Spektren der Wellenfronten von Messort A und B, dann erhält man folgende Formel: $\frac{{{F \left\{f\left(t\right)\right\} ⋅ {e}^{α ⋅ m ⋅ L} ⋅ {e}^{- jβ ⋅ m ⋅ L}}^{︷}}^{F \left\{{f}_{A}\left(t\right)\right\}}}{{{F \left\{f\left(t\right)\right\} ⋅ {e}^{α ⋅ \left(1-m\right) ⋅ L} ⋅ {e}^{- jβ ⋅ \left(1-m\right) ⋅ L}}_{︸}}_{F \left\{{f}_{B}\left(t\right)\right\}}} = {e}^{α ⋅ \left(2m-1\right) ⋅ L} ⋅ {e}^{- jβ ⋅ \left(2m-1\right) ⋅ L}$

Hier wurde die Entfernung I von der Fehlerstelle zum Messort durch die Gesamt-Leitungslänge L multipliziert mit per-unit (p.u.) Entfernung der Seite A zum Fehlerort bezogen auf die Leitungslänge ersetzt. Damit wird die Fehlerentfernung vom Fehlerort A zum Fehler m·L und die Entfernung vom Fehlerort zur Seite B (1-m)·L.

Entsprechend dem Verschiebungssatz der Fouriertransformation ist die Zeitdifferenz zwischen den zeitverschoben an den Messorten A und B eintreffenden Wellenfronten damit: $Δ t \left(ω\right) = \frac{1}{ω} ⋅ arg \left(\frac{F \left\{{f}_{A}\left(t\right)\right\}}{F \left\{{f}_{B}\left(t\right)\right\}}\right) = \frac{β ⋅ \left(2m-1\right) ⋅ L}{ω}$

Damit ist die frequenzabhängige Zeitdifferenz zwischen den Wellenfronten erfindungsgemäß direkt aus den Phasendifferenzen der Frequenzspektren der Wellenfronten (und den Leitungsdaten) bestimmbar.

### Exemplarische Ausführungsbeispiele

Gemäß einem Ausführungsbeispiel ist die Steuervorrichtung ferner eingerichtet zum Bestimmen des Fehlerorts basierend auf der frequenzabhängigen Zeitdifferenz. Dies kann den Vorteil haben, dass der Fehlerort präzise lokalisiert werden kann, insbesondere mit einem einseitigen oder einem zweiseitigen Fehlerorter. Bekannte Verfahren können direkt verwendet werden, um anhand der Zeitdifferenz eine Fehlerortung durchzuführen.

Gemäß einem Ausführungsbeispiel ist das erste Signal ein Puls einer Wellenfront bzw. der ersten Wellenfront (einer Wanderwelle). Gemäß einem Ausführungsbeispiel ist das zweite Signal ebenfalls ein Puls der Wellenfront bzw. der ersten Wellenfront (der Wanderwelle). Gemäß einem Ausführungsbeispiel sind das erste Signal und das zweite Signal (im Wesentlichen) identisch. In einem Ausführungsbeispiel werden beide Signale/Pulse von demselben Fehlerereignis generiert und sind daher im Wesentlichen identisch, jedoch zeitlich zueinander verschoben. In einem Ausführungsbeispiel wird das erste Signal zu einem ersten Zeitpunkt an einem ersten Messort erfasst und das zweite Signal wird zu einem zweiten Zeitpunkt an einem räumlich entfernten zweiten Messort erfasst. In einem weiteren Ausführungsbeispiel werden beide Signal an demselben Messort erfasst, sind zeitlich jedoch durch die Leitung verschoben, z.B. durch Reflexionen und/oder Dämpfung.

Gemäß einem Ausführungsbeispiel weist die Vorrichtung ferner auf: eine Abtastvorrichtung (z.B. ein ADC) zum Abtasten des ersten Signals, um ein abgetastetes erstes Signal zu erhalten und/oder Abtasten des zweiten Signals, um ein abgetastetes zweites Signal zu erhalten. Gemäß einem Ausführungsbeispiel weist die Abtastvorrichtung einen Analog-Digital-Wandler (ADC) auf. Gemäß einem Ausführungsbeispiel weist der ADC einen Delta-Sigma ADC auf. Dies kann den Vorteil haben, dass zuverlässige und etablierte Techniken direkt eingesetzt werden können. Bevorzugt wird für das erste Signal und das zweite Signal ein vergleichbarer/identischer ADC eingesetzt. Dies kann den Vorteil haben, dass eine Zeitverschiebung beim Abtasten nicht berücksichtigt werden muss.

Gemäß einem Ausführungsbeispiel ist die Abtastrate der Abtastvorrichtung 1,5 MHz, oder weniger, insbesondere 1 MHz oder weniger, insbesondere 0,75 MHz oder weniger, weiter insbesondere 0,5 MHz oder weniger. Dies kann den Vorteil haben, dass eine geringere Abtastrate verwendet werden kann (geringere Aufwendungen/Geräteanforderungen, Kostenersparnis), während die Auflösung gleich oder höher als bei konventionellen Verfahren sein kann.

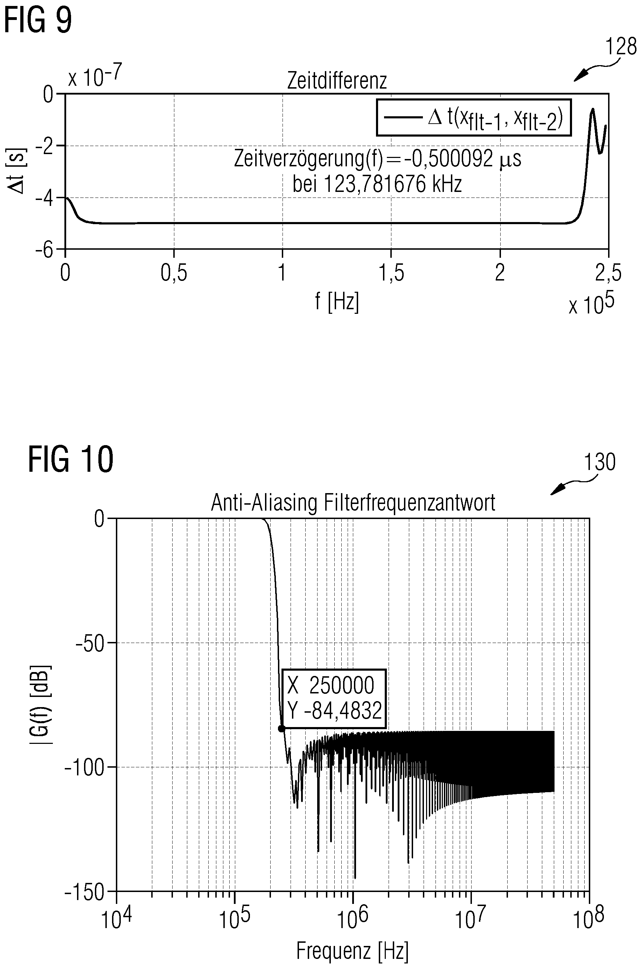

Gemäß einem Ausführungsbeispiel ist das Abtastintervall größer als die frequenzabhängige Zeitdifferenz. Konventionell ist das Abtastintervall kleiner als die Zeitdifferenz. Beispielsweise wird konventionell (siehe oben) eine Abtastrate von 5 MHz eingesetzt, was einem Abtastintervall von 200 ns entspricht. Erfindungsgemäß (vergleiche Figur 9) kann aber auch eine Abtastrate von 500 kHz ausreichend sein, was dann einem Abtastintervall von 2 µs entspricht. In diesem Beispiel beträgt die bestimmte Zeitdifferenz 0,5 µs, ist also viermal kleiner als das Abtastintervall. Entsprechend kann vorteilhaft die Abtastrate verringert werden, während die Auflösung erhöht wird.

Gemäß einem Ausführungsbeispiel laufen das erste Signal und das zweite Signal entlang einer Leitung (in einem Netz). Gemäß einem Ausführungsbeispiel weist das Bestimmen der Zeitdifferenz auf: Berücksichtigen von Leitungsdaten (z.B. Länge, Durchmesser, Verzweigungen, Material, Dämpfung, Homogenität, etc.). In einem Ausführungsbeispiel können die Leitungsdaten verwendet werden, um basierend auf der Phasendifferenz die frequenzabhängige Zeitdifferenz zu bestimmen.

Gemäß einem Ausführungsbeispiel weist die Erfassungsvorrichtung auf:
i) eine erste Erfassungseinheit zum Erfassen des ersten Signals, und/oder
ii) eine zweite Erfassungseinheit zum Erfassen des zweiten Signals.

Gemäß einem Ausführungsbeispiel sind die erste Erfassungseinheit und die zweite Erfassungseinheit in einem einseitigen Fehlerorter verbaut (z.B. als zwei Wellendetektoren in einem Fehlerorter-Gerät). Gemäß einem Ausführungsbeispiel sind die erste Erfassungseinheit und die zweite Erfassungseinheit räumlich getrennt in einem zweiseitigen Fehlerorter verbaut, insbesondere an zwei verschiedenen Messorten (z.B. ein erster Wellendetektor an einem ersten Messort in einem Netz und ein zweiter Wellendetektor an eine zweiten Messort in dem Netz). Dies kann den Vorteil haben, dass die Vorrichtung (als Fehlerorter) flexibel implementiert werden kann für verschiedene Anwendungen.

Gemäß einem Ausführungsbeispiel weist die Vorrichtung ferner auf: eine Tiefpassfilter-Vorrichtung zum Filtern des ersten Signals und/oder des zweiten Signals. Gemäß einem Ausführungsbeispiel weist die Tiefpassfilter-Vorrichtung auf: eine erste Tiefpassfilter-Einheit zum Filtern des ersten Signals (z.B. an dem ersten Messort) und/oder eine zweite Tiefpassfilter-Einheit zum Filtern des zweiten Signals (z.B. an dem zweiten Messort). Gemäß einem Ausführungsbeispiel haben die erste Tiefpassfilter-Einheit und die zweite Tiefpassfilter-Einheit dieselben Einstellungen/Parameter, insbesondere dieselbe Grenzfrequenz und/oder Zeitkonstante.

Gemäß einem Ausführungsbeispiel ist die Grenzfrequenz der Tiefpassfilter-Vorrichtung (bzw. der ersten/zweiten Tiefpassfilter-Einheit) kleiner als die halbe Abtastrate (fa/2). Gemäß einem Ausführungsbeispiel erfüllt die Grenzfrequenz (fc) folgende Bedingungen bezüglich der Abtastrate (fa): fc > fa/4 und fc < fa/2. Dies kann den Vorteil haben, dass ein effizienter Anti-Aliasing Filter realisiert werden kann. Ferner kann dies den Vorteil haben, dass die Kurvenform der ansteigenden Signalflanke verbessert werden kann.

Gemäß einem Ausführungsbeispiel weist die Vorrichtung ferner auf: eine Hochpassfilter-Vorrichtung zum Filtern des ersten Signals und/oder des zweiten Signals. Gemäß einem Ausführungsbeispiel weist die Hochpassfilter-Vorrichtung auf: eine erste Hochpassfilter-Einheit zum Filtern des ersten Signals und/oder eine zweite Hochpassfilter-Einheit zum Filtern des zweiten Signals. Gemäß einem Ausführungsbeispiel haben die erste Hochpassfilter-Einheit und die zweite Hochpassfilter-Einheit dieselben Einstellungen/Parameter, insbesondere dieselbe Grenzfrequenz und/oder Zeitkonstante.

Gemäß einem Ausführungsbeispiel liegt die Zeitkonstante der Hochpassfilter-Vorrichtung unter der Zeitkonstante, welche sich aus dem X/R (Blindwiderstand/Wirkwiderstand)-Verhältnis des Leitungsabschluss ergibt. Gemäß einem Ausführungsbeispiel ist die Grenzfrequenz der Hochpassfilter-Vorrichtung > 1 kHz. Dies kann den Vorteil haben, dass die Kurvenform der abfallenden Signalflanke verbessert werden kann.

Gemäß einem Ausführungsbeispiel sind die Tiefpassfilter-Vorrichtung und/oder die Hochpassfilter-Vorrichtung derart konfiguriert, dass der Einfluss der Leitung, insbesondere der Leitungsdämpfung, minimiert wird.

Gemäß einem Ausführungsbeispiel ist die Steuervorrichtung ferner eingerichtet zum Verwenden eines Datenfensters, insbesondere ein Tukey-Fenster. Gemäß einem Ausführungsbeispiel ist der Mittelpunkt des Datenfensters von einer vorbestimmten Triggerschwelle definiert. Dadurch kann die Auswertung, insbesondere eine Fouriertransformation, effizient und zuverlässig gelingen.

Gemäß einem Ausführungsbeispiel ist die Genauigkeit der Bestimmung des Fehlerorts höher als das Abtastintervall multipliziert mit der Wellen-Ausbreitungsgeschwindigkeit. Entsprechend kann sich erfindungsgemäß vorteilhaft eine sehr hohe Genauigkeit ergeben.

Gemäß einem Ausführungsbeispiel ist die Vorrichtung als Wanderwellen-Fehlerorter ausgestaltet, insbesondere ein einseitiger Fehlerorter oder ein zweiseitiger Fehlerorter. Während ein zweiseitiger Fehlerorter präziser sein kann, können mit einem einseitigen Fehlerorter Kosten und Aufwendungen gespart werden. Ein besonderer Vorteil der Erfindung kann darin liegen, dass auch ein einseitiger Fehlerorter effizient und zuverlässig einsetzbar ist.

Gemäß einem Ausführungsbeispiel ist die Vorrichtung für ein Netz, insbesondere ein Energieübertragungsnetz und/oder ein Verteilernetz, konfiguriert. Gemäß einem Ausführungsbeispiel weist das Fehlerorten auf: Orten eines Fehlstroms, insbesondere einen Erdschlusses und/oder einen Kurzschluss. Gemäß einem Ausführungsbeispiel haben das erste Signal und das zweite Signal denselben Ursprung an dem Fehlerort haben. Dies kann den Vorteil haben, dass relevante Problemstellungen effizient gelöst werden können.

Gemäß einem Ausführungsbeispiel weist das Detektieren des Fehler-Ereignisses auf: Detektieren einer Wanderwelle, insbesondere der Laufzeit der Wanderwelle. Gemäß einem Ausführungsbeispiel weist das Orten des Fehlers auf: Orten eines Fehlerstroms, insbesondere eines Erdschlusses/Kurzschlusses. Dadurch können häufige Fehler in Netzen effizient und zuverlässig erkannt (und beseitigt) werden.

Gemäß einem Ausführungsbeispiel weist das Netz ein elektrisches Netz, insbesondere ein Energieübertragungsnetz/Verteilnetz, insbesondere ein Mittelspannungsnetz, auf. Insbesondere in Mittelspannungsnetzen wird eine Ortung von Wanderwellen häufig als unwirtschaftlich angesehen. Dieses Vorurteil kann mit dem beschriebenen Verfahren jedoch überwunden werden, so dass auch eine wirtschaftliche Fehlerortung in Mittelspannungsnetzen ermöglicht ist.

Gemäß einem Ausführungsbeispiel weist das Detektieren des Fehler-Ereignisses auf: Erstellen eines Zeitstempels an dem korrespondierenden Fehler-Detektor. Dadurch kann der Ankunftszeitpunkt der (ersten) Wellenfront präzise erfasst und verglichen werden.

Gemäß einem Ausführungsbeispiel weist das (vermaschte) Netz ein Internet of Things (IOT) Netzwerk auf. Insbesondere können die Geräte (wie Fehler-Detektoren) an ein loT Netzwerk angeschlossen sein. Gemäß einem Ausführungsbeispiel weist das loT Netzwerk einen loT Vermittler (Broker) auf, und wobei ein Erweitern/Verändern des vermaschten Netzes aufweist: Aktualisieren des loT Vermittlers. Auf diese Weise können neue Geräte bzw. Updates schnell und hocheffizient durchgeführt werden. Mit dem loT Vermittler können z.B. zusätzliche Geräte direkt und flexibel in die Netz-Topologie eingegeben werden.

Gemäß einem Ausführungsbeispiel kann erfindungsgemäß zumindest eines der folgenden Merkmale vorliegen:
i) die Abtastrate eines Wanderwellen-Fehlerorters beträgt weniger als 1 MHz.
ii) die angegebene Ortungsgenauigkeit ist höher als das Abtastintervall des eingesetzten Recorders multipliziert mit der Wellen-Ausbreitungsgeschwindigkeit.
iii) der Wanderwellen-Fehlerorter wird zur einseitigen Ortung eingesetzt.

Es ist zu beachten, dass Ausführungsformen der Erfindung unter Bezugnahme auf verschiedene Gegenstände beschrieben wurden. Insbesondere wurden einige Ausführungsformen unter Bezugnahme auf Verfahrensansprüche beschrieben, während andere Ausführungsformen unter Bezugnahme auf Vorrichtungsansprüche beschrieben wurden. Ein Fachmann wird jedoch aus dem Vorstehenden und der folgenden Beschreibung entnehmen, dass, sofern nicht anders angegeben, neben jeder Kombination von Merkmalen, die zu einer Art von Gegenstand gehören, auch jede Kombination von Merkmalen, die sich auf verschiedene Gegenstände beziehen, als von diesem Dokument offenbart gilt. Dies insbesondere auch zwischen Merkmalen der Verfahrensansprüche und Merkmalen der Vorrichtungsansprüche.

Die oben definierten Aspekte und weitere Aspekte der vorliegenden Erfindung ergeben sich aus den nachstehend zu beschreibenden Beispielen der Ausführungsformen und werden unter Bezugnahme auf die Beispiele der Ausführungsformen erläutert. Die Erfindung wird im Folgenden unter Bezugnahme auf Ausführungsformen, auf die die Erfindung jedoch nicht beschränkt ist, näher beschrieben.

### Kurze Beschreibung der Zeichnungen

Figur 1 zeigt eine Vorrichtung zur Fehlerortung, gemäß einem exemplarischen Ausführungsbeispiel der Erfindung.
Figur 2 zeigt einen Erdschlusseintritt als Fehler in einem Spannung-Zeit Diagramm unter Verwenden von Clarke-Komponenten, gemäß einem exemplarischen Ausführungsbeispiel der Erfindung.
Figur 3 zeigt einen hochpassgefilterten Ausschnitt aus Figur 2, gemäß einem exemplarischen Ausführungsbeispiel der Erfindung.
Figur 4 zeigt die Kurvenform eines Wellenfront-Pulses und ein assoziiertes Datenfenster, gemäß einem exemplarischen Ausführungsbeispiel der Erfindung.
Figur 5 zeigt die zeitverschobenen Wellenfront-Pulse vor und nach dem Abtasten, gemäß einem exemplarischen Ausführungsbeispiel der Erfindung.
Figur 6 zeigt die abgetasteten Signale und das assoziierte Datenfenster, gemäß einem exemplarischen Ausführungsbeispiel der Erfindung.
Figur 7 zeigt ein Frequenzspektrum der abgetasteten Signale von Figur 6 nach einer Fouriertransformation, gemäß einem exemplarischen Ausführungsbeispiel der Erfindung.
Figur 8 zeigt die Phasendifferenz zwischen den Frequenzspektren der Signale von Figur 7, gemäß einem exemplarischen Ausführungsbeispiel der Erfindung.
Figur 9 zeigt die frequenzabhängige Zeitdifferenz basierend auf der Phasendifferenz von Figur 8, gemäß einem exemplarischen Ausführungsbeispiel der Erfindung.
Figur 10 zeigt eine tiefpassgefilterte (anti-aliasing) Frequenzantwort, gemäß einem exemplarischen Ausführungsbeispiel der Erfindung.

Die Figuren 11 und 12 zeigen ein konventionelle Zeitspektren mit hoher Abtastrate bei geringer Auflösung.

### Detaillierte Beschreibung der Zeichnungen

Die Darstellung in den Zeichnungen sind schematisch. Es wird darauf hingewiesen, dass in unterschiedlichen Abbildungen ähnliche oder identische Elemente oder Merkmale mit den gleichen Bezugszeichen oder mit Bezugszeichen versehen sind, die sich von den entsprechenden Bezugszeichen nur innerhalb der ersten Ziffer unterscheiden. Um unnötige Wiederholungen zu vermeiden, werden Elemente oder Merkmale, die bereits in Bezug auf eine zuvor beschriebene Ausführungsform erläutert wurden, an einer späteren Stelle der Beschreibung nicht noch einmal erläutert.

Darüber hinaus werden räumlich relative Begriffe wie "vorne" und "hinten", "oben" und "unten", "links" und "rechts" usw. verwendet, um die Beziehung eines Elements zu einem anderen Element zu beschreiben, wie in den Abbildungen dargestellt. So können die räumlich relativen Begriffe auf verwendete Orientierungen zutreffen, die von der in den Abbildungen dargestellten Orientierung abweichen. Offensichtlich beziehen sich diese räumlich relativen Begriffe lediglich auf eine Vereinfachung der Beschreibung und die in den Abbildungen gezeigte Orientierung und sind nicht notwendigerweise einschränkend, da eine Vorrichtung gemäß einer Ausführungsform der Erfindung andere Orientierungen als die in den Abbildungen dargestellten annehmen kann, insbesondere wenn sie verwendet wird.

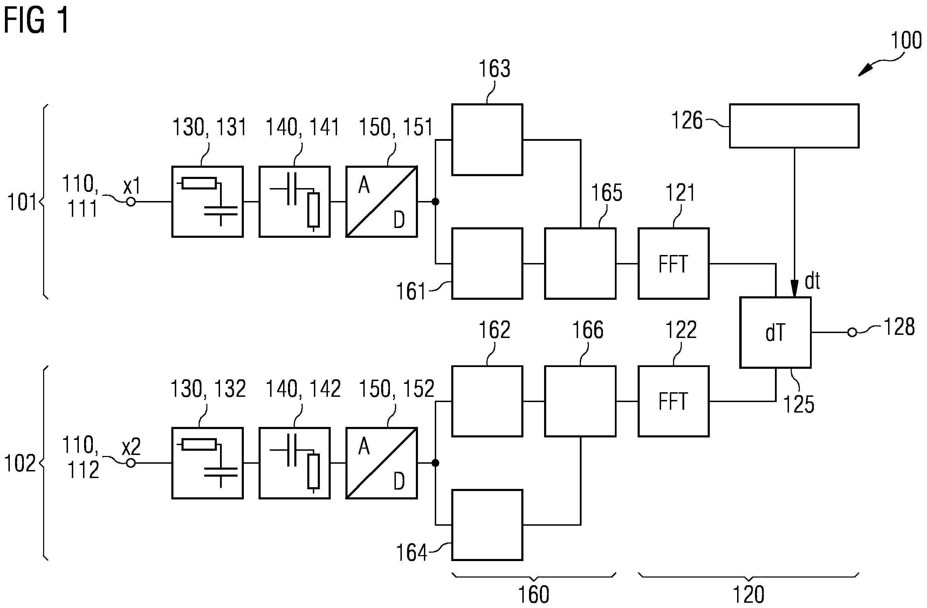

**Figur 1** zeigt eine Vorrichtung 100 zur Fehlerortung, gemäß einem exemplarischen Ausführungsbeispiel der Erfindung. Die Vorrichtung 100 weist in diesem Beispiel zwei Signalpfade 101 und 102 auf. Diese können in demselben Gerät (insbesondere an einem Messort) oder in zwei räumlich getrennten Geräten implementiert werden (insbesondere an zwei oder mehr Messorten). Die Vorrichtung 100 weist eine Erfassungsvorrichtung 110 auf mit einer ersten Erfassungseinheit 111 im ersten Signalpfad 101 und einer zweiten Erfassungseinheit 112 im zweiten Signalpfad 102. Die Erfassungseinheiten 111, 112 sind als Wanderwellen-Detektoren ausgebildet und haben jeweils eine Antenne zur Signalerfassung. Im gezeigten Beispiel wird das erste Signal x1 (erste Wellenfront der Wanderwelle) an der ersten Erfassungseinheit 111 erfasst, während das zweite Signal x2 (zeitverschobene erste Wellenfront der Wanderwelle) an der zweiten Erfassungseinheit 112 erfasst wird. Die Signale x1, x2 werden gleichzeitig durch einen Fehlstrom im Netz generiert, treffen jedoch zeitverzögert an den Erfassungseinheiten 111, 112 (insbesondere Messorten) ein.

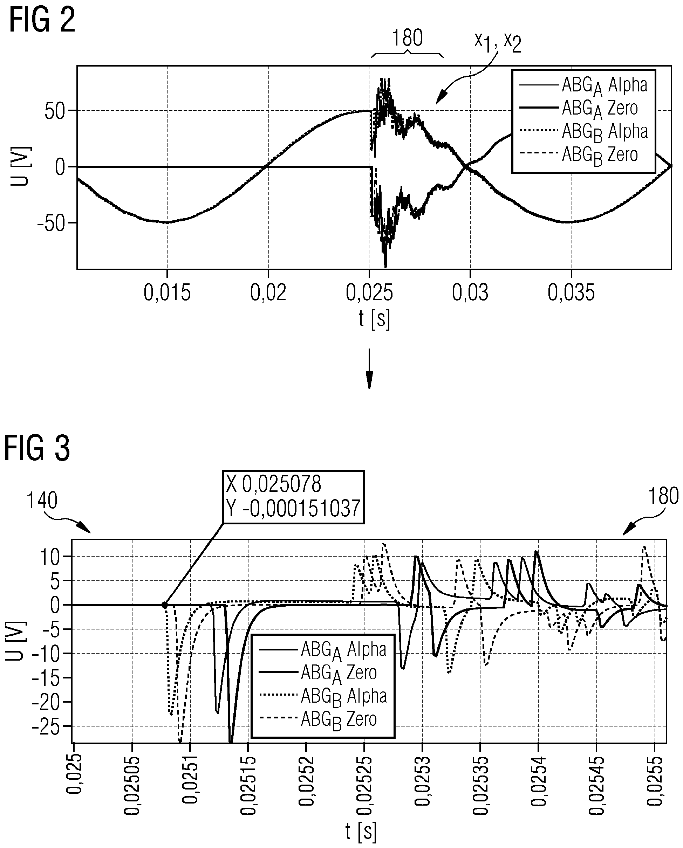

Die erfassten Signale x1, x2 werden jeweils gefiltert von einer Tiefpass-Filter Vorrichtung 130 und einer Hochpass-Filter Vorrichtung 140. Insbesondere wird in diesem Beispiel das erste Signal x1 von einer ersten Tiefpassfilter-Einheit 131 gefiltert und das zweite Signal x2 von einer zweiten Tiefpassfilter-Einheit 132. Das erste Signal x1 wird ferner von einer ersten Hochpassfilter-Einheit 141 gefiltert und das zweite Signal x2 wird ferner von einer zweiten Hochpassfilter-Einheit 142 gefiltert. Hierbei können bestimmte Einstellungen der Filter 130, 140 hinsichtlich Grenzfrequenz und Zeitkonstante vorgenommen werden (vergleiche oben und Figuren 3 und 10).

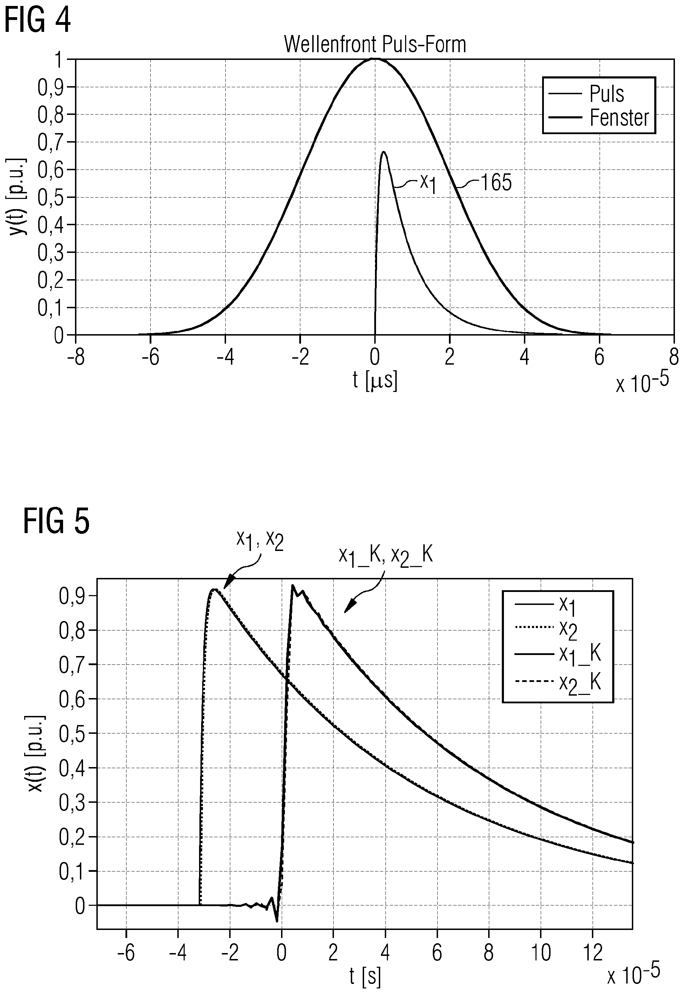

Die gefilterten analogen Signale x1, x2 werden dann digitalisiert mittels einer Abtastvorrichtung 150. Im gezeigten Ausführungsbeispiel wird das erste gefilterte Signal x1 von einem ersten ADC 151 abgetastet und das zweite gefilterte Signal x2 wird von einem zweiten ADC 152 abgetastet. Hierbei kann es zu einer zeitlichen Verschiebung kommen (vergleiche Figur 5), wobei diese jedoch vernachlässigt werden kann, wenn derselbe ADC 151, 152 verwendet wird.

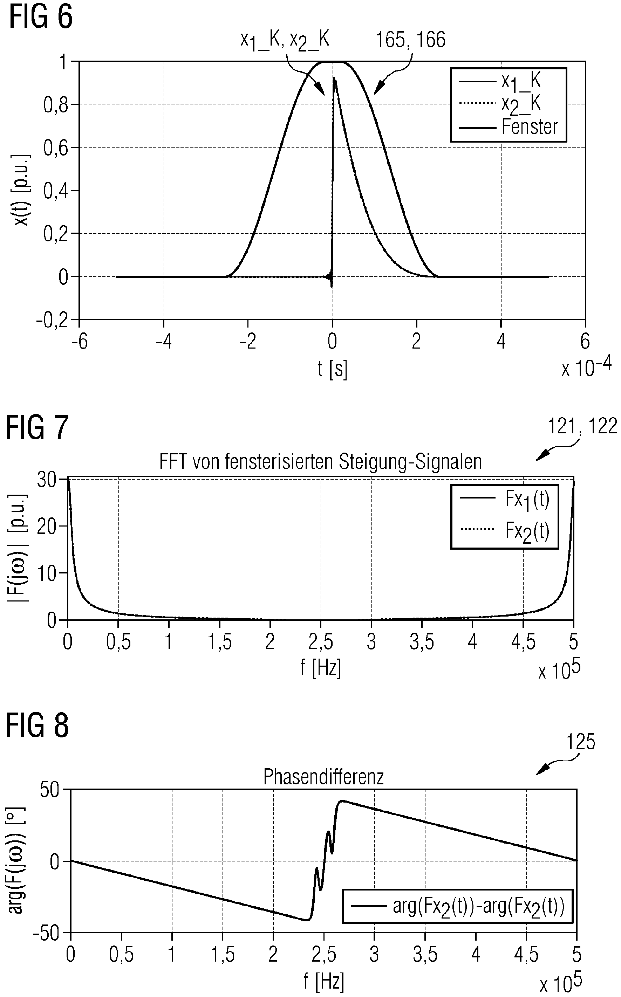

Der erste Pfad 101 und der zweite Pfad 102 weisen jeweils einen Ringpuffer 160 auf mit einem ersten Puffer 161, einem zweiten Puffer 162, einem ersten Trigger 163, einem zweiten Trigger 164, einer ersten Fensterfunktion 165, und einer zweiten Fensterfunktion 166. Die Trigger 163, 164 dienen hierbei zum Erkennen eines Wanderwellen-Ereignisses. Wenn ein solches vorliegt, kann jeweils ein Datenfenster 165, 166 auf die abgetasteten Signale x1_k, x2_k angewendet werden (vergleiche Figuren 4 und 6).

Dem Ringpuffer 160 nachgeschaltet ist in diesem Beispiel die Steuervorrichtung 120. In einem anderen Ausführungsbeispiel kann der Ringpuffer 160 (insbesondere auch die Filtervorrichtungen 130, 140 und/oder die Abtastvorrichtung 150) als Teil der Steuervorrichtung 120 ausgebildet sein. Die Steuervorrichtung 120 ist eingerichtet zum Bestimmen eines ersten Frequenzspektrums 121 bezüglich des abgetasteten ersten Signals x1_k und eines zweiten Frequenzspektrums 122 bezüglich des abgetasteten zweiten Signals x2_k. Aus den beiden Frequenzspektren 121, 122 bestimmt die Steuervorrichtung 120 dann eine Phasendifferenz 125. Unter Berücksichtigung der Leitungsdaten 126 kann die Steuervorrichtung 120 dann eine frequenzabhängige Zeitdifferenz 128 zwischen dem ersten Signal x1 und dem zweiten Signal x2 basierend auf der bestimmten Phasendifferenz 125 ermitteln. Die frequenzabhängige Zeitdifferenz 125 kann als Basis dienen, um den Fehler im Netz zu orten.

Das Ausführungsbeispiel der Figur 1 kann auch wie folgt beschrieben werden. Die Signale x1 und x2, deren Zeitdifferenz zwischen den ersten Wellenfronten gemessen werden soll, werden jeweils von einem Hochpass 140 und einem Tiefpass 130 gefiltert und von einem Delta Sigma ADC 150 in die Abtastwertefolgen x1_k und x2_k umgewandelt. Diese Abtastwerte werden in einem Ringpuffer 161, 162 gespeichert. Sobald der parallel an diese Abtastwertefolgen angeschlossene Trigger-Baustein 163, 164 die Flanke einer Wellenfront mit einer an sich bekannten Methode (z.B. Leveltrigger) erkennt, wird der Puffer 161, 162 eingefroren und ein Datenfenster symmetrisch zum Trigger-Zeitpunkt positioniert. Die Abtastwerte in diesem Datenfenster werden anschließend im Fenster-Block 165, 166 mit der Fensterfunktion skaliert und mit dem FFT-Block 121, 122 in den Frequenzbereich transformiert. Im dT-Block 125 wird der Quotient der in den beiden FFT-Blöcken gebildeten Spektren 121, 122 berechnet und ein Vektor der Phasenwinkel des Quotienten der beiden FFTs berechnet 125. Der Vektor des Phasenwinkels 125 wird durch den mit 2 Pi multiplizierten korrespondierenden Frequenzvektor dividiert. Als Ergebnis erhält man den Vektor der frequenzabhängigen Zeitdifferenzen 128.

**Figur 2** zeigt einen Erdschlusseintritt als Fehler 180 in einem Spannung-Zeit Diagramm unter Verwenden von Clarke-Komponenten (aus den drei (Phasen) Komponenten werden die zwei Komponenten Alpha und Zero berechnet), gemäß einem exemplarischen Ausführungsbeispiel der Erfindung. Figur 2 zeigt spezifisch ein Beispiel eines L1-E-Erdschlusses in Clarke-Komponenten bei einem Erdschlusseintritt bei t = 25 ms. Der transiente Vorgang beim Erdschlusseintritt ist nach ca. 5 ms abgeklungen.

**Figur 3** zeigt einen hochpassgefilterten Ausschnitt aus Figur 2, gemäß einem exemplarischen Ausführungsbeispiel der Erfindung. Dieses Diagramm zeigt die gleichen, allerdings hochpassgefilterten, Signale in einem Ausschnitt von ca. 500 µs nach Erdschlusseintritt mit einer Abtastrate von 500 kHz.

Die hochpassgefilterten Wellenfronten sind durch folgende Signaleigenschaften gekennzeichnet: die an beiden Leitungsterminals eintreffenden ersten Wellenfronten haben den gleichen Ursprung an der Fehlerstelle (Spannungseinbruch bei Fehlereintritt) und repräsentieren demnach das gleiche Signal, nur zeitverschoben und unterschiedlich gefiltert.

Die Kurvenform der ansteigenden Flanke dieser Signale wird bestimmt durch
- das im Abtastsystem eingesetzte Anti-Aliasing Filter (Zeitkonstante des Tiefpassfilters) und
- die frequenzabhängige Dämpfung der Leitung.

Die Kurvenform der ansteigenden Flanke dieser Signale wird bestimmt durch:
- das X/R Verhältnis der Abschlussimpedanz der Leitung am jeweiligen Abgang, und
- der Grenzfrequenz (bzw. Knickfrequenz) des eingesetzten Hochpasses (Hochpass-Zeitkonstante) im Signalpfad.

Die Eigenschaften des Signalpfades (Hochpass-Zeitkonstante und Anti-Aliasing Filter) können für alle erfassten Signale gleich ausgelegt werden und müssen daher nicht als Variablen im Algorithmus berücksichtigt werden. Diese Parameter können allerdings so ausgelegt werden, dass sie die wesentlichen Einflussfaktoren auf die Signalform darstellen und damit den Einfluss der von Leitungsdämpfung und Topologie abhängigen Einflussgrößen minimieren.

Das kann z.B.: durch folgende Auslegung von Tiefpassfilter und Hochpassfilter erreicht werden:

Die Grenzfrequenz (bzw. Eckfrequenz) des Tiefpassfilters ist kleiner als die frequenzabhängige Dämpfung der Leitung. Das ist für Knickfrequenzen des Tiefpassfilters von kleiner 1 MHz für Freileitungen erfüllt. Da für die hier vorgesehenen Abtastraten von fa ≤ 512 kHz das Anti-Aliasing Filter eine Knickfrequenz unterhalb fa/2 haben muss, ist diese Bedingung erfüllt.

Die Zeitkonstante des eingesetzten Hochpassfilters ist kleiner als die sich aus dem X/R-Verhältnis des Leitungsabschlusses ergebende Zeitkonstante. Für ein X/R-Verhältnis von 1 ergibt sich eine Knickfrequenz von 50 Hz (T = 3.18 ms). Damit ist diese Bedingung in den Aerial Modes (alpha und beta Clarke-Komponente) in jedem Fall erfüllt. Die Hochpass-Knickfrequenz wird so gewählt, dass die charakteristische Impedanz der Leitung im Pass-Band des Hochpasses konstant ist. Das ist für Knickfrequenzen oberhalb von 1 kHz der Fall. In isolierten Netzen ergeben sich für die zero-Komponente sehr kleine Zeitkonstanten, die Knickfrequenzen > 1 kHz entsprechen. Das kann bei der Auslegung der Algorithmen für die einseitige Fehlerortung berücksichtigt werden.

Die folgende Zusammenstellung fasst die Anforderungen des Algorithmus an das Abtastsystem in einem Ausführungsbeispiel zusammen:
i) 256 kHz ≤ fa ≤ 512 kHz (Tiefpassfilter mit fa/4 < fc <f_{fa}/2)
ii) Hochpassfilter mit 1kHz < *f_{c}* im Signalweg

**Figur 4** zeigt die Kurvenform eines Wellenfront-Pulses (z.B. von dem ersten Signal x1) und ein assoziiertes Datenfenster 165, gemäß einem exemplarischen Ausführungsbeispiel der Erfindung. Aus der Charakterisierung der Wellenfront-Pulse ergeben sich z.B. folgende Zeitfenster zur Isolation eines einzelnen Pulses aus dem Spannungs- oder Stromsignal:
i) Die Steilheit der steigenden Flanke des Pulses wird durch die Zeitkonstante des Anti-Aliasing Filters bestimmt. Nach einer Zeit von 4T wird bereits $1 - {e}^{- \frac{4 ⋅ T}{T}} = 1 - {e}^{- 4} = 1 - 0.018 = 98.2 %$ der Amplitude der Wellenfront erreicht.
ii) Die Steilheit der fallenden Flanke des Pulses wird durch die Zeitkonstante des Hochpassfilters definiert.
iii) Da die Zeitkonstanter des Hochpassfilters um ca. zwei Zehnerpotenzen größer ist als die Zeitkonstante des Anti-Aliasing Filters, wird die Kurvenform des Pulses (Formel für Sprungantwort der Analogstrecke) $y \left(t\right) = {F}^{- 1} \left\{\frac{{jωT}_{HP}}{1 + {jωT}_{HP}}⋅\frac{1}{1 + {jωT}_{AAF}}⋅\frac{1}{jω}\right\} = \left(1-{e}^{- \frac{t}{{T}_{AAF}}}\right) ⋅ {e}^{- \frac{t}{{T}_{HP}}}$
von der Hochpass-Zeitkonstante dominiert. Figur 10 (siehe unten) zeigt die Kurvenform der Sprungantwort für 150 kHz Eckfrequenz des Tiefpass-Filters und 20 kHz Eckfrequenz des Hochpasses. Damit ist ein Datenfenster von 50 µs zur Isolation eines einzelnen Pulses ausreichend.

Zur Isolation eines einzelnen Pulses aus dem Abtastwertestrom wird in diesem Beispiel ein Tukey-Fenster mit 64 Abtastwerten benutzt. Bei 500 kHz Abtastrate hat dann eine Halbseite des symmetrischen Fensters eine Länge von 32*2 µs = 64 µs. Das Fenster ist etwas größer, um Ungenauigkeiten bei der Flankenerkennung kompensieren zu können. Die Fenstermitte wird an die Position der erkannten Flanke gesetzt. Sinnvoll ist die Ausweitung des Fensters auf die zur Verfügung stehende Zeit bis zum Eintreffen des folgende Pulses. Für die Bestimmung der Zeitverschiebung der Pulse wird nun die beschriebene FFT-Methode benutzt.

**Figur 5** zeigt die zeitverschobenen Wellenfront-Pulse vor und nach dem Abtasten, gemäß einem exemplarischen Ausführungsbeispiel der Erfindung. Figur 5 zeigt die zeitverschobenen Impulse der ersten Wellenfront x1 am Messort A und x2 am Messort B als Analogsignale und nach der Abtastung mit einer Abtastrate von 500 kHz. Die in Figur 5 dargestellten Impulse x1 und x2 sind um 0,5 µs zeitverschoben. Das entspricht den 0,25-fachen des Abtastintervalls von 2 µs der verwendeten Abtastrate von 500 kHz.

**Figur 6** zeigt die abgetasteten Signale x1_k, x2_k und das assoziierte Datenfenster 165, 166, gemäß einem exemplarischen Ausführungsbeispiel der Erfindung. Figur 6 zeigt die gebildeten Fenster mit den Abtastwerten für die FFT der Pulse der ersten Wellenfront im Zeitbereich: der Vektor der Abtastwerte für die FFT wird durch alle Abtastwerte innerhalb des Bereiches der Fensterfunktion w(k) gebildet, in der w(k) ungleich null ist. Der Mittelpunkt von w(k) wird auf den Abtastwert festgelegt, an dem die Abtastfolge eine festgelegte Trigger-Schwelle überschreitet.

**Figur 7** zeigt ein Frequenzspektrum 121, 122 der abgetasteten Signale von Figur 6 nach einer Fouriertransformation, gemäß einem exemplarischen Ausführungsbeispiel der Erfindung. Figur 7 zeigt die aus den Vektoren der Abtastwerte der ersten Wellenfront gebildeten FFTs 121, 122, die Amplitude der beiden FFTs, sowie die Amplitude des Quotienten der beiden Spektren. Die Spektren sind nahezu deckungsgleich und an der Achse der Nyquist-Frequenz gespiegelt. Im Bereich des Stop-Bands vom Anti-Aliasing-Filter entstehen Ungenauigkeiten durch Aliasing bzw. die starke Dämpfung das Anti-Aliasing-Filters. Dieser Frequenzbereich wird von der Auswertung ausgeschlossen.

**Figur 8** zeigt die Phasendifferenz 125 zwischen den Frequenzspektren 121, 122 der Signale von Figur 7, gemäß einem exemplarischen Ausführungsbeispiel der Erfindung. Figur 8 zeigt die Phase des Quotienten der beiden Spektren. Hier ergibt sich das gleiche Bild wie im Amplitudenspektrum.

**Figur 9** zeigt die frequenzabhängige Zeitdifferenz 128 basierend auf der Phasendifferenz 125 von Figur 8, gemäß einem exemplarischen Ausführungsbeispiel der Erfindung. Figur 9 zeigt die aus der Phasendifferenz 125 berechnete frequenzabhängige Zeitverschiebung 128 der Wellenfronten. Im Bild ist nur das halbe Frequenzband bis zur Nyquist-Frequenz (halbe Abtastfrequenz) dargestellt. Im Bild zeigen sich Unsicherheitsbereiche für sehr kleine Frequenzen und im Bereich des Stop-Bandes des Anti-Aliasing-Filters. Diese Bereiche werden aus der Auswertung ausgeschlossen. Die Zeitdifferenz von 0,5 µs zwischen den beiden Impulsen kann mit einer Genauigkeit von ca. 0.01 ns gemessen werden, obwohl das Abtastintervall 1/500 kHz = 2 µs beträgt. Das ist mit den aus dem Stand der Technik bekannten Verfahren möglich.

**Figur 10** zeigt eine tiefpassgefilterte (anti-aliasing) Frequenzantwort, gemäß einem exemplarischen Ausführungsbeispiel der Erfindung. Die Analogsignale und die abgetasteten Signale sind um die Phasenverzögerung der Anti-Aliasing Filter zeitverschoben. Da diese Zeitverschiebung eine Eigenschaft des eingesetzten Abtastsystems ist und an den beiden Messorten A und B die gleichen Abtastsysteme eingesetzt werden können, muss diese Zeitdifferenz nicht im Verfahren berücksichtigt werden. Damit das der Fall ist, wird im Abtastsystem z.B. ein Delta-Sigma-ADC eingesetzt. Damit sind die nicht vermeidbaren Toleranzen des analogen Anti-Aliasing Filters so klein, dass sie vernachlässigt werden können, da die Eckfrequenz dieses Filters sich an der primären Abtastrate des Delta-Sigma-ADCs orientiert und ein einfaches Filter 1. Ordnung als Anti-Aliasing Filter ausreichend ist.

Dieses Filter weist an der Nyquist-Frequenz des Abtastsystems von 250 kHz eine Dämpfung von ca. 84.5 dB auf. Das nutzbare Passband des Filters geht bis ca. 200 kHz. Damit erreicht dieses Abtastsystem mit einer Ausgaberate des Delta-Sigma-ADCs von 500 kHz die gleiche nutzbare Analogbandbreite wie das weiter oben vorgestellte Abtastsystem mit 10 MHz Abtastrate (siehe Figuren 11 und 12).

Es sei darauf hingewiesen, dass der Begriff "aufweisend" andere Elemente oder Schritte nicht ausschließt und die Verwendung des Artikels "ein" eine Vielzahl nicht ausschließt. Auch Elemente, die in Verbindung mit verschiedenen Ausführungsformen beschrieben werden, können kombiniert werden. Es ist auch darauf hinzuweisen, dass Bezugszeichen in den Ansprüchen nicht so ausgelegt werden sollten, dass sie den Umfang der Ansprüche einschränken.

Unabhängig vom grammatikalischen Geschlecht eines bestimmten Begriffs sind Personen männlicher, weiblicher oder anderer Geschlechteridentität mit umfasst.

### Bezugszeichen

- 100: Vorrichtung
- 101: Erster Signalpfad
- 102: Zweiter Signalpfad
- 110: Erfassungsvorrichtung
- 111: Erste Erfassungseinheit
- 112: Zweite Erfassungseinheit
- 120: Steuervorrichtung
- 121: Erstes Frequenzspektrum
- 122: Zweites Frequenzspektrum
- 125: Phasendifferenz
- 126: Leitungsdaten
- 128: Frequenzabhängige Zeitdifferenz
- 130: Tiefpassfilter-Vorrichtung
- 131: Erste Tiefpassfilter-Einheit
- 132: Zweite Tiefpassfilter-Einheit
- 140: Hochpassfilter-Vorrichtung
- 141: Erste Hochpassfilter-Einheit
- 142: Zweite Hochpassfilter-Einheit
- 150: Abtastvorrichtung
- 151: Erste Abtast-Einheit
- 152: Zweite Abtast-Einheit
- 160: Ringpuffer
- 161: Erster Puffer
- 162: Zweiter Puffer
- 163: Erster Trigger
- 164: Zweiter Trigger
- 165: Erste Fensterfunktion
- 166: Zweites Fensterfunktion
- 180: Fehler, Erdschluss

## Patentansprüche

1. Eine Vorrichtung (100), aufweisend:
eine Erfassungsvorrichtung (110) zum Erfassen eines ersten Signals (x1) und eines zweiten Signals (x2),
wobei das erste Signal (x1) und das zweite Signal (x2) zueinander zeitverschoben sind; und
eine Steuervorrichtung (120), eingerichtet zum Bestimmen
eines ersten Frequenzspektrums (121) bezüglich des ersten Signals (x1) und eines zweiten Frequenzspektrums (122) bezüglich des zweiten Signals (x2),
einer Phasendifferenz (125) bezüglich des ersten Frequenzspektrums (121) und des zweiten Frequenzspektrums (122), und
einer frequenzabhängigen Zeitdifferenz (128) zwischen dem ersten Signal (x1) und dem zweiten Signal (x2) basierend auf der bestimmten Phasendifferenz (125).

2. Die Vorrichtung (100) gemäß Anspruch 1, wobei die Steuervorrichtung (100) ferner eingerichtet ist zum
Bestimmen des Fehlerorts basierend auf der frequenzabhängigen Zeitdifferenz (125).

3. Die Vorrichtung (100) gemäß Anspruch 1 oder 2,
wobei das erste Signal (x1) und das zweite Signal (x2) jeweils ein Puls einer Wellenfront sind, insbesondere einer Wanderwelle; und/oder
wobei das erste Signal (x1) und das zweite Signal (x2) im Wesentlichen identisch sind.

4. Die Vorrichtung (100) gemäß einem der vorhergehenden Ansprüche, ferner aufweisend:
eine Abtastvorrichtung (150) zum
Abtasten des ersten Signals (x1), um ein abgetastetes erstes Signal (x1_k) zu erhalten, und Abtasten des zweiten Signals (x2), um ein abgetastetes zweites Signal (x2_k) zu erhalten, insbesondere wobei die Abtastvorrichtung (150) einen Analog-Digital-Wandler, ADC, aufweist, weiter insbesondere wobei der ADC einen Delta-Sigma Wandler aufweist.

5. Die Vorrichtung (100) gemäß Anspruch 4,
wobei die Abtastrate der Abtastvorrichtung (150) 1 MHz oder weniger, insbesondere 0,75 MHz oder weniger, weiter insbesondere 0,5 MHz oder weniger, ist.

6. Die Vorrichtung (100) gemäß Anspruch 4 oder 5,
wobei das Abtastintervall der Abtastvorrichtung (150) größer als die bestimmte frequenzabhängige Zeitdifferenz (128) ist.

7. Die Vorrichtung (100) gemäß einem der vorherigen Ansprüche, wobei das erste Signal (x1) und das zweite Signal (x2) eine Leitung durchlaufen, und wobei das Bestimmen der frequenzabhängigen Zeitdifferenz (128) aufweist:
Berücksichtigen von Leitungsdaten (126).

8. Die Vorrichtung (100) gemäß einem der vorherigen Ansprüche,
wobei die Erfassungsvorrichtung (110) aufweist:
eine erste Erfassungseinheit (111) zum Erfassen des ersten Signals (x1); und
eine zweite Erfassungseinheit (112) zum Erfassen des zweiten Signals (x2);
wobei die erste Erfassungseinheit (111) und die zweite Erfassungseinheit (112) in einem einseitigen Fehlerorter verbaut sind;
oder
wobei die erste Erfassungseinheit (111) und die zweite Erfassungseinheit (112) räumlich getrennt in einem zweiseitigen Fehlerorter verbaut sind, insbesondere an zwei verschiedenen Messorten.

9. Die Vorrichtung (100) gemäß einem der vorherigen Ansprüche, ferner aufweisend:
eine Tiefpassfilter-Vorrichtung (130) zum Filtern des ersten Signals (x1) und des zweiten Signals (x2),
wobei die Grenzfrequenz (fc) der Tiefpassfilter-Vorrichtung (130) kleiner als die halbe Abtastrate (fa) ist,
insbesondere wobei gilt: fc > fa/4 und/oder fc < fa/2.

10. Die Vorrichtung (100) gemäß einem der vorherigen Ansprüche, ferner aufweisend:
eine Hochpassfilter-Vorrichtung (140) zum Filtern des ersten Signals (x1) und des zweiten Signals (x2),
wobei die Zeitkonstante der Hochpassfilter-Vorrichtung (140) kleiner ist als die Zeitkonstante, welche sich aus dem X/R-Verhältnis des Leitungsabschluss ergibt; und/oder
wobei die Grenzfrequenz (fc) der Hochpassfilter-Vorrichtung (140) größer als 1 kHz ist.

11. Die Vorrichtung (100) gemäß einem der vorherigen Ansprüche, wobei die Steuervorrichtung (120) ferner eingerichtet zum:
Verwenden eines Datenfensters (165, 166), insbesondere ein Tukey-Fenster, insbesondere wobei der Mittelpunkt des Datenfensters (165, 166) von einer vorbestimmten Trigger-Schwelle definiert ist.

12. Die Vorrichtung (100) gemäß einem der vorherigen Ansprüche,
wobei die Genauigkeit der Bestimmung des Fehlerorts höher ist als das Abtastintervall multipliziert mit der Wellen-Ausbreitungsgeschwindigkeit.

13. Die Vorrichtung (100) gemäß einem der vorherigen Ansprüche,
wobei die Vorrichtung als Wanderwellen-Fehlerorter eingerichtet ist,
insbesondere als einseitiger Fehlerorter oder zweiseitiger Fehlerorter.

14. Die Vorrichtung (100) gemäß einem der vorherigen Ansprüche, aufweisend zumindest eines der folgenden Merkmale:
wobei die Vorrichtung (100) für ein Netz, insbesondere ein Energieübertragungsnetz und/oder ein Verteilernetz, konfiguriert ist;
wobei das Fehlerorten aufweist: Orten eines Fehlstroms, insbesondere einen Erdschlusses und/oder einen Kurzschluss,
wobei das erste Signal und das zweite Signal denselben Ursprung an dem Fehlerort haben;
wobei die Tiefpassfilter-Vorrichtung aufweist:
eine erste Tiefpassfilter-Einheit zum Filtern des ersten Signals, und
eine zweite Tiefpassfilter-Einheit zum Filtern des zweiten Signals,
wobei die erste Tiefpassfilter-Einheit und die zweite Tiefpassfilter-Einheit dieselben Parameter haben, insbesondere dieselbe Grenzfrequenz;
wobei die Hochpassfilter-Vorrichtung aufweist:
eine erste Hochpassfilter-Einheit zum Filtern des ersten Signals, und
eine zweite Hochpassfilter-Einheit zum Filtern des zweiten Signals,
wobei die erste Hochpassfilter-Einheit und die zweite Hochpassfilter-Einheit dieselben Parameter haben, insbesondere dieselbe Zeitkonstante;
wobei die Tiefpassfilter-Vorrichtung und die Hochpassfilter-Vorrichtung derart konfiguriert sind, dass der Einfluss der Leitungsdämpfung minimiert wird.

15. Ein Verfahren zum Bestimmen eines Fehlerorts, das Verfahren aufweisend:
Erfassen eines ersten Signals (x1) und eines zweiten Signals (x2),
wobei das erste Signal (x1) und das zweite Signal (x2) zueinander
zeitverschoben sind;
Bestimmen eines ersten Frequenzspektrums (121) bezüglich des ersten Signals (x1) und eines zweiten Frequenzspektrums (122) bezüglich des zweiten Signals (x2);
Bestimmen einer Phasendifferenz (125) zwischen dem ersten Frequenzspektrum (121) und dem zweiten Frequenzspektrum (122); und
Bestimmen einer frequenzabhängigen Zeitdifferenz (128) zwischen dem ersten Signal (x1) und dem zweiten Signal (x2) basierend auf der bestimmten Phasendifferenz (125).
